# EUROPEAN PATENT SPECIFICATION

(11) **EP 3 252 815 B1**
(45) Date of publication and mention of the grant of the patent: **15.06.2022**
(21) Application number: 16743056.0
(22) Date of filing: 08.01.2016
(51) Int. Cl.: H01L 21/8234, H01L 27/088, H01L 29/78, H01L 29/06, H01L 27/02, H01L 27/12

(54) **CURRENT CONTROL SEMICONDUCTOR ELEMENT AND CURRENT CONTROL DEVICE USING SAME**
STROMSTEUERUNGSHALBLEITERBAUELEMENT UND STROMSTEUERUNGSVORRICHTUNG DAMIT
ÉLÉMENT SEMI-CONDUCTEUR DE COMMANDE DE COURANT ET DISPOSITIF DE COMMANDE DE COURANT FAISANT APPEL À CE DERNIER

(30) Priority: 26.01.2015 JP 2015011930
(43) Date of publication of application: 06.12.2017
(73) Proprietor: Hitachi Astemo, Ltd., Hitachinaka-shi, Ibaraki 312-8503 (JP)
(72) Inventor: WADA, Shinichirou, Tokyo 100-8280 (JP)
(74) Representative: MERH-IP Matias Erny Reichl Hoffmann Patentanwälte PartG mbB
(86) International application number: PCT/JP2016/050423
(87) International publication number: WO 2016/121452

(56) References cited:
- WO-A1-2012/002100
- JP-A- H0 574 802
- JP-A- 2000 022 140
- JP-A- 2000 217 347
- US-A1- 2012 326 207
- US-A1- 2014 284 714
- US-B1- 6 180 966

## Description

### Technical field

The present invention relates to a current control device such as a current control semiconductor element suitable for detecting an output current of an application specific integrated circuit (ASIC) or the like which outputs a driving current with high accuracy, and an engine control unit (ECU) using the same.

### Background Art

In order to control an electric actuator such as a motor, and a solenoid with high accuracy, it is necessary to control a driving current with high accuracy. Therefore, it is required to accurately detect the driving current value of the electric actuator.

One method for detecting a current with high accuracy is to measure a terminal voltage at the time of energization of a shunt resistor using a highly accurate shunt resistor. However, this method has problems of cost increase due to introduction of a shunt resistor, heat generation, and loss of shunt resistance.

As a method to solve this problem, there is a method in which a sense MOSFET for detecting current is connected in parallel to a main MOSFET that outputs a driving current (see, for example, PTL 1). By setting the gate width of the sense MOSFET to, for example, 1/100 with respect to the main MOSFET, since the current flowing through the sense MOSFET can be 1/100 of the current flowing in the main MOSFET, it is possible to solve the problem of cost increase, heat generation and loss compared to the method using a shunt resistor.

On the other hand, current detection by the sense MOSFET depends on the accuracy of the current ratio (sense ratio; molecule is the current value of the sense MOSFET and the denominator is the current value of the main MOSFET) of the main MOSFET and the sense MOSFET.

Here, the main MOSFET and the sense MOSFET generate heat during current driving and the temperature increases. In a general current sense circuit, the voltages at the source, gate and drain terminals of the main MOSFET are set to be the same as the voltages at the respective terminals of the sense MOSFET. The unit MOSFET constituting the main MOSFET and the sense MOSFET has the same structure. For this reason, the power per unit area of the element is the same; however, since the size of the main MOSFET is larger than that of the sense MOSFET, the ratio of the amount of heat dissipation from an element peripheral region to the amount of heat generation becomes smaller. As a result, the temperature of the main MOSFET is higher than the temperature of the sense MOSFET. Here, since the current amount of the MOSFET decreases as the temperature increases, the current reduction rate of the main MOSFET becomes larger than the current reduction rate of the sense MOSFET. As a result, the sense ratio increases as the driving current increases, that is, as the power increases, there arises a problem that the accuracy of current detection decreases.

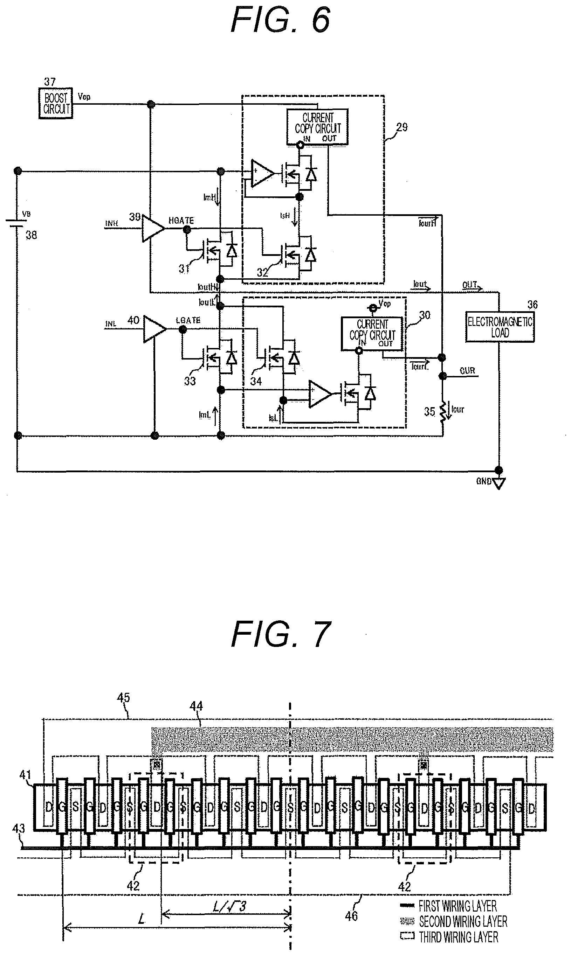

In order to solve this problem, as shown in FIG. 7, when a part of a multi-finger MOSFET forming the main MOSFET 41 is used as the sense MOSFET 42 and the distance from the center of the multi-finger MOSFET to the furthest channel is L, there is a method of using the channel closest to the position of L/ (√3) from the center of the multi-finger MOSFET as the channel of the sense MOSFET 42 (refer to PTL 2). Here, when the power density in the main MOSFET 41 is uniform, the temperature distribution can be approximated by a quadratic function, and the temperature becomes the highest in the central portion. When the channel current is approximated by the linear equation of the temperature, the distribution of the channel current is expressed by I(x) = αX² + β ...(1). From this, the average value Iave of the channel current of the main MOSFET 41 is Iave = (1/L)∫I(x)dx = (α/3)L² + β ...(2), and becomes equal to the current of the channel of the sense MOSFET 42 located at X = L/(√3). As a result, it is possible to suppress a change in the sense ratio with respect to a change in the driving current of the main MOSFET 41.

### Citation List

### Patent literature

PTL 1: JP 2006-203415 A
PTL 2: JP 2012-9763 A
PTL 3: JP 2014-44975 A
PTL 4: US 2014/284714 A1
PTL 5: US 6 180 966 B1
PTL 4 describes a semiconductor element with a main MOSFET and a sense MOSFET each of them surrounded by a trench groove.
PTL 5 describes a trench gate type semiconductor device with a current sensing cell.

### Summary of Invention

### Technical Problem

However, the method of using a part of the multi-finger MOSFET constituting the main MOSFET as the sense MOSFET has the following problems in application, which are solved by the semiconductor element according to claim 1.

First, because the sense MOSFET is disposed in the main MOSFET, the wiring layout of the terminal lead-out of the main MOSFET is restricted by the wiring layout of the lead-out of the source terminal or the drain terminal of the sense MOSFET. In general, since the main MOSFET drives a large current, it is necessary to make a regular wiring layout so as to reduce the influence of the wiring resistance and prevent a local temperature rise. However, due to the presence of the terminal lead-out wiring of the sense MOSFET, the wiring layout of that portion breaks regularity. As a result, there arises a problem that the current density of the wiring layer of the main MOSFET adjacent to the sense MOSFET increases and the parasitic resistance increases.

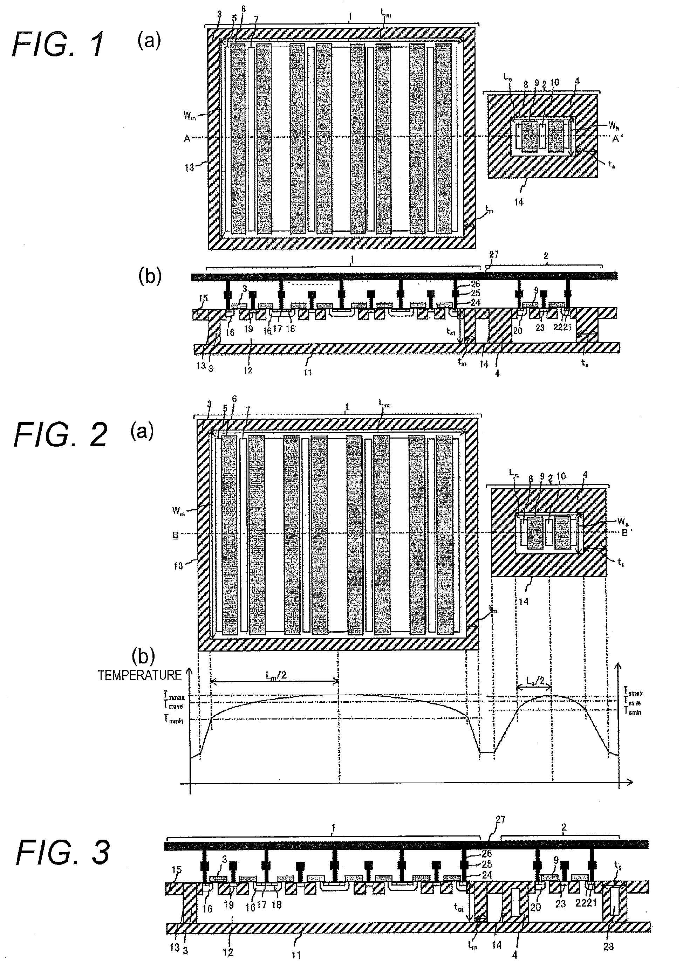

Secondly, in the multi-finger MOSFET constituting the main MOSFET, in the case where one of the source and the drain is MOSFET structure electrically connected via the substrate, the configuration of a current detection circuit is restricted. For example, in the current detection circuit provided on the high side shown in FIG. 2 of Literature 3, the drains of the main MOSFET and the sense MOSFET are required to be electrically isolated from each other, this configuration cannot be realized when the mutual drains are electrically connected via the semiconductor substrate. In the current detection circuit provided on the low side, the sources of the main MOSFET and the sense MOSFET are required to be electrically isolated from each other; however, this configuration cannot be realized when the mutual sources are electrically connected via the semiconductor substrate. As described above, the method of using a part of the multi-finger MOSFET as the sense MOSFET is restricted in the circuit configuration.

Thirdly, when the main MOSFET is divided in a gate length direction and a part is used for the sense MOSFET, since a boundary region of division does not operate as a MOSFET, there is a problem that the layout area becomes larger than the case where the main MOSFET is not divided. This problem occurs when the gate width of the sense MOS becomes smaller than the gate width of the multi-finger MOSFET constituting the main MOSFET in order to increase the sense ratio. This increases the layout area of the main MOSFET and increases the chip cost.

It is an object of the present invention to provide a current control semiconductor element which can suppress a change in sense ratio with respect to a change in driving current of the main MOSFET without causing the above three problems and a current control device using the same.

### Solution to Problem

A semiconductor element for current control according to claim 1 is provided. Among other features, the semiconductor element for current control includes: on the same semiconductor substrate, a main MOSFET that drives a current; and a sense MOSFET that is connected in parallel to the main MOSFET and performs current detection of the main MOSFET, wherein the main MOSFET is formed while being surrounded by a first trench groove, the sense MOSFET is formed while being surrounded by a second trench groove, and a thermal conduction coefficient of the first trench groove surrounding the main MOSFET is larger than a thermal conduction coefficient of the second trench groove surrounding the sense MOSFET.

### Advantageous Effects of Invention

According to the present invention, a thermal conduction coefficient (λₘ/tₘ) derived from the width tₘ of the trench groove surrounding the main MOSFET and the thermal conductivity λₘ is set to be larger than a thermal conduction coefficient (λ_{s/}tₛ) derived from a width tₛ of the trench groove surrounding the sense MOSFET and the thermal conductivity λₛ. As a result, the amount of heat dissipation per unit length from the trench groove of the sense MOSFET can be made smaller than the amount of heat dissipation per unit length from the trench groove of the main MOSFET. As a result, the difference between the temperature of the main MOSFET and the temperature of the sense MOSFET can be reduced, and the change in the sense ratio with respect to the change in the driving current of the main MOSFET can be suppressed.

### Brief Description of the Drawings

[FIG. 1] FIG. 1(a) is a plan layout view of a main MOSFET and a sense MOSFET used in a current control semiconductor element according to a first embodiment of the present invention. FIG. 1(b) is a longitudinal sectional view in a region indicated by A-A' in FIG. 1(a).
[FIG. 2] FIG. 2(a) is a plan layout view of a main MOSFET and a sense MOSFET used in the current control semiconductor element according to the first embodiment of the present invention. FIG. 2(b) is a view showing a temperature distribution in a substrate region indicated by B-B' in FIG. 2(a).
[FIG. 3] FIG. 3 is a cross-sectional view of a main MOSFET and a sense MOSFET used for a current control semiconductor element according to a second embodiment of the present invention.
[FIG. 4] FIG. 4 is a plan layout view of a main MOSFET and a sense MOSFET used in the current control semiconductor element according to a third embodiment of the present invention.
[FIG. 5] FIG. 5 is a plan layout view of a main MOSFET and a sense MOSFET used in the current control semiconductor element according to an example not forming part of the claimed invention.
[FIG. 6] FIG. 6 is a circuit diagram of a current control device having a microcontroller that controls the current control semiconductor element according to the first embodiment of the present invention.
[FIG. 7] FIG. 7 is a plan layout view of a main MOSFET and a sense MOSFET used in a conventional current control semiconductor element.

### Description of Embodiments

(1) In order to achieve the above purpose, the present invention provides a semiconductor element with the features of claim 1, in particular, among other features: on the same semiconductor substrate, a main MOSFET that drives a current; and a sense MOSFET that is connected in parallel to the main MOSFET and performs current detection of the main MOSFET, wherein the main MOSFET is formed while being surrounded by a first trench groove, the sense MOSFET is formed while being surrounded by a second trench groove, and a thermal conduction coefficient of the first trench groove surrounding the main MOSFET is larger than a thermal conduction coefficient of the second trench groove surrounding the sense MOSFET. As a result, the amount of heat dissipation per unit length of the first trench groove is made larger than the amount of heat dissipation per unit length of the second trench groove.

With such a configuration, the temperature difference between the sense MOSFET and the main MOSFET can be reduced, and the change in the sense ratio with respect to the change in the driving current of the main MOSFET can be suppressed. As a result, the accuracy of current detection by the sense MOSFET can be improved.

According to the present invention, a thermal conduction coefficient (λₘ/tₘ) derived from the width tₘ of the trench groove surrounding the main MOSFET and the thermal conductivity λₘ is set to be larger than a thermal conduction coefficient (λₛ/tₛ) derived from a width tₛ of the trench groove surrounding the sense MOSFET and the thermal conductivity λₛ. As a result, the amount of heat dissipation per unit length from the trench groove of the sense MOSFET can be made smaller than the amount of heat dissipation per unit length from the trench groove of the main MOSFET. As a result, the difference between the temperature of the main MOSFET and the temperature of the sense MOSFET can be reduced, and the change in the sense ratio with respect to the change in the driving current of the main MOSFET can be suppressed.

Further, according to the present invention, the thermal conductivity λₘ of the trench groove surrounding the main MOSFET is made larger than the thermal conductivity λₛ of the trench groove surrounding the sense MOSFET. As a result, the amount of heat dissipation per unit length from the trench groove of the sense MOSFET can be made smaller than the amount of heat dissipation per unit length from the trench groove of the main MOSFET. As a result, the difference between the average temperature of the main MOSFET and the average temperature of the sense MOSFET can be reduced, and the change in the sense ratio with respect to the change in the driving current of the main MOSFET can be suppressed.

Further, according to the present invention, the groove width tm of the trench groove surrounding the main MOSFET is made larger than the groove width tₛ of the trench groove surrounding the sense MOSFET. As a result, similarly, the amount of heat dissipation per unit length from the trench groove of the sense MOSFET can be made smaller than the amount of heat dissipation per unit length from the trench groove of the main MOSFET. As a result, the difference between the average temperature of the main MOSFET and the average temperature of the sense MOSFET can be reduced, and the change in the sense ratio with respect to the change in the driving current of the main MOSFET can be suppressed.

Further, according to the present invention, the thermal resistance Rₜₕₘ of the trench groove surrounding the main MOSFET and the thermal resistance Rₜₕₛ of the trench groove surrounding the sense MOSFET are formed so as to be inversely proportional to the area of the semiconductor element region surrounded by each trench groove. Accordingly, the amount of heat dissipation from the trench groove can be proportional to the area of the semiconductor element region. As a result, the difference between the amount of heat generation per unit area of the semiconductor element region and the amount of heat dissipation can be made identical between the main MOSFET and the sense MOSFET, and the temperature difference of the MOSFET can be further reduced. Therefore, it is possible to further suppress the change in the sense ratio with respect to the change in the driving current of the main MOSFET.

Further, according to an embodiment, the sense MOSFET and the main MOSFET have a multi-finger MOSFET structure having the same channel spacing, and by surrounding each with a trench groove, regular pattern arrangement is possible without restriction on the wiring layout of the main MOSFET.

Further, according to the present invention, the sense MOSFET and the main MOSFET are isolated from each other by surrounding each of the sense MOSFET and the main MOSFET with a trench groove. Therefore, in the multi-finger MOSFET, it is possible to eliminate the restriction that the source and drain of the sense MOSFET and the main MOSFET are electrically connected via the substrate.

Further, according to the present invention, since the sense MOSFET and the main MOSFET are each surrounded by a trench groove, the size of the sense MOSFET does not affect the size of the main MOSFET. That is, when the sense ratio is small, it is possible to eliminate the problem that the main MOSFET is divided in the gate length direction to reduce the layout area efficiency of the main MOSFET. Hereinafter, embodiments of the present invention will be described with reference to the drawings. Although the case of using the NMOSFET is described in this embodiment, it may be a PMOSFET. Further, in this embodiment, the MOSFET is formed on an SOI substrate, but a Si substrate may be used. (First Embodiment) The first embodiment of the present invention will be described with reference to FIGS. 1 and 2. FIG. 1(a) is a plan layout view of a main MOSFET 1 and a sense MOSFET 2 used in a current control semiconductor element according to the present embodiment. FIG. 1(b) shows a longitudinal sectional view in a region indicated by A-A' in FIG. 1(a) .

Both the main MOSFET 1 and the sense MOSFET 2 have a multi-finger MOSFET structure in which a plurality of channels are arranged in a line at equal intervals. The MOSFET has a Lateral Double Diffused MOS (LDMOS) structure in which an electric field strength between drains 19, 23 and gates 3, 9 is relaxed. The main MOSFET 1 is surrounded by a trench groove 13 in which an insulating film 3 is buried, and the sense MOSFET 2 is surrounded by a trench groove 14 in which an insulating film 4 is buried. The insulating film 3 and the insulating film 4 are made of SiO₂ film, and a width tₘ of the trench groove 13 is smaller than a width tₛ of the trench groove 14. Here, the thermal conduction coefficient of the trench groove is expressed as λ/t using the thermal conductivity λ of the SiO₂ film and the width t of the trench groove. Accordingly, the thermal conduction coefficient (λ/tₘ) of the trench groove 13 is larger than the thermal conduction coefficient (λ/tₛ) of the trench groove 14. This means that the amount of heat dissipation per unit length of the trench groove is larger in the trench groove 13 than in the trench groove 14.

Next, the junction temperature of the main MOSFET 1 and the sense MOSFET 2 during current driving of the main MOSFET 1 will be described with reference to FIG. 2. FIG. 2(a) is the same as FIG. 1(a) and shows a plan layout view, and FIG. 2(b) shows the temperature in the region indicated by B-B'. A temperature at the center of the main MOSFET is Tₘₘₐₓ, a temperature at the end portion is Tₘₘᵢₙ, an average temperature is Tₘₐᵥₑ, a temperature at the center portion of the sense MOSFET is Tₛₘₐₓ, a temperature at the end portion is Tₛₘᵢₙ, and an average temperature is Tₛₐᵥₑ.

In the case where the main MOSFET 1 and the sense MOSFET 2 are operating at a uniform power density in the semiconductor element region, the temperature in the Si device region surrounded by the trench grooves 13 and 14 becomes a maximum value Tmax at the center part as described above, and can be approximated by a quadratic function having a minimum value Tₘᵢₙ at the end. The temperature becomes the smallest at the edge is due to heat dissipation from the trench groove. However, the amount of heat dissipation from the trench groove is proportional to the value obtained by multiplying the thermal conduction coefficient λ/t of the trench groove by the cross sectional area (2 × (L + W) × tₛᵢ) of the trench groove. That is, it is proportional to 2 × (L + W) of a peripheral length of the trench groove. Here, a length of the semiconductor element region is represented by L, a width by W, and a depth by tₛᵢ. On the other hand, since the calorific value is proportional to the area (L × W) of the Si device region, when the thermal conduction coefficient λ/t is the same in the trench grooves 13 and 14, the average temperature Tₐᵥₑ determined by the difference between the amount of heat generation and the amount of heat dissipation is higher in the main MOSFET 1 having a larger area of the Si device region. In the present invention, by making the thermal conduction coefficient of the trench groove 13 larger than that of the trench groove 14, the amount of heat dissipation from the trench groove 14 of the sense MOSFET 2 is relatively reduced, so that a temperature Tₛₐᵥₑ of the sense MOSFET 2 is made to approach a temperature Tₘₐᵥₑ of the main MOSFET 1. As a result, it is possible to further suppress the change in the sense ratio with respect to the change in the driving current of the main MOSFET.

According to an example, the widths of the trench grooves 13 and 14 are formed to satisfy tₘ = α × 2×(Lₘ + Wₘ)/(Lₘ × Wₘ)tₛ = α × 2 × (Ls + Wₛ / (Ls × Wₛ), so that the amount of heat dissipation from the trench groove described above can be proportional to the area (L × W) of the semiconductor element region. Since the amount of heat generation is also proportional to the area (L × W) of the semiconductor element region, the average temperature Tₐᵥₑ determined by the difference between the amount of heat generation and the amount of heat dissipation can be made identical between the main MOSFET 1 and the sense MOSFET 2. As a result, it is possible to further suppress the change in the sense ratio with respect to the change in the driving current of the main MOSFET.

Although the insulating film 3 and the insulating film 4 are made of SiO₂ film in this embodiment, it is not necessary that they are made of the same material, and may be formed of different materials so that the thermal conductivity λₘ of the trench groove 13 is larger than the thermal conductivity λₛ of the trench groove 14. As a result, even if, in an example not forming part of the claimed invention, the width tₘ of the trench groove 13 and the width tₛ of the trench groove 14 are the same, the thermal conduction coefficient (λₘ/tₘ) of the trench groove 13 can be made larger than the thermal conduction coefficient (λ_{s/}tₛ) of the trench groove 14, and the same effect can be obtained. (Second Embodiment) The second embodiment of the present invention will be described with reference to FIG. 3. FIG. 3 shows a cross-sectional view of a semiconductor element according to the present invention. A main MOSFET 1 is surrounded by a trench groove 13 and a sense MOSFET 2 is surrounded by a trench groove 14. The trench groove 13 is formed by embedding a SiO₂ film 3, the trench groove 14 is partially embedded with the SiO₂ film 4, and a gap 28 is formed in a part thereof.

Since the thermal conductivity of the gap 28 of the trench groove 14 is smaller than that of the SiO₂ film, the thermal conductivity λₘ of the trench groove 13 is larger than the thermal conductivity λₛ of the trench groove 14. As a result, the thermal conduction coefficient λₘ/tₘ of the trench groove 13 is larger than the thermal conduction coefficient λₛ/tₛ of the trench groove 14. This indicates that the amount of heat dissipation per unit length of the trench groove is larger in the trench groove 13 than in the trench groove 14. Accordingly, the amount of heat dissipation from the trench groove 14 of the sense MOSFET 2 is relatively reduced, so that a temperature Tₛₐᵥₑ of the sense MOSFET 2 is made to approach a temperature Tₘₐᵥₑ of the main MOSFET 1.

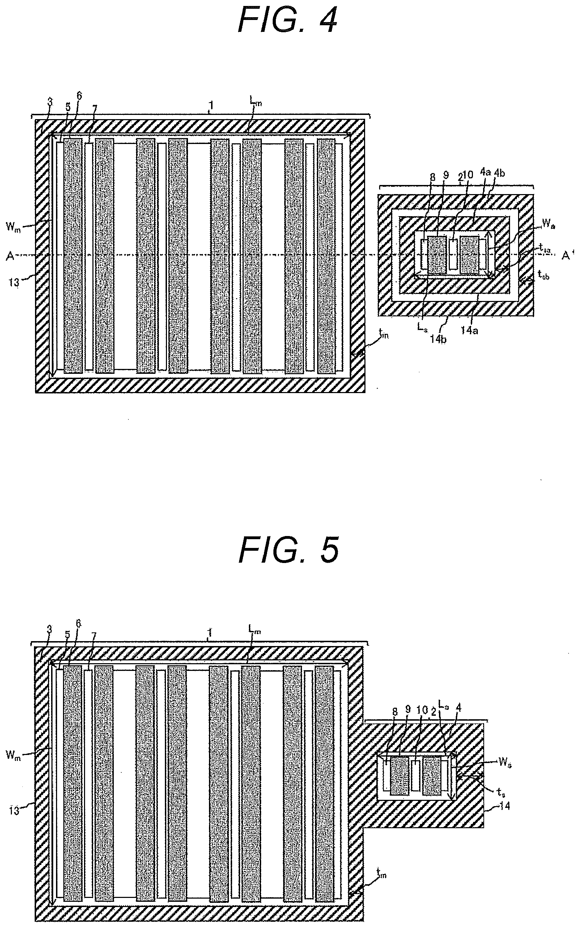

According to an example, the trench groove 13 is formed so that the thermal conduction coefficient λₘ/tₘ of the trench groove 13 becomes λₘ/tₘ = β × Lm × Wm/{2 × (Lm + Wₘ)}. The trench groove 14 is formed so that the thermal conduction coefficient λₛ/tₛ of the trench groove 14 becomes λₛ/tₛ = β × Lₛ × Wₛ/{2 x (Lₛ + Wₛ)}. Since the thermal resistance Rₜₕ of the trench groove is derived by dividing the reciprocal of the thermal conduction coefficient by the cross sectional area of the trench groove {2 × (L + W) × t_{Si}}, the thermal resistance Rₜₕₘ of the trench groove 13 and the thermal resistance Rₜₕₛ of the trench groove 14 are Rₜₕₘ = 1/(β × Lₘ × Wm × t_{Si})Rₜₕₛ = 1/(β x Lₛ × Ws × t_{Si}). Therefore, the thermal resistance of the trench grooves 13, 14 is inversely proportional to the area (L × W) of the semiconductor element region. As a result, the amount of heat dissipation from the trench groove is proportional to the area (L × W) of the semiconductor element region. On the other hand, when the electric power per area is the same, the amount of heat generation of the main MOSFET 1 and the sense MOSFET 2 is also proportional to the area (L × W) of the semiconductor element region, the average temperature Tₐᵥₑ determined by the difference between the amount of heat generation and the amount of heat dissipation can be made identical between the main MOSFET 1 and the sense MOSFET 2. As a result, it is possible to further suppress the change in the sense ratio with respect to the change in the driving current of the main MOSFET. (Third Embodiment) The third embodiment of the present invention will be described with reference to FIG. 4. FIG. 4 shows a plan view of a semiconductor element according to the present invention. A main MOSFET 1 is surrounded by one trench groove 13 and a sense MOSFET 2 is surrounded by two trench grooves 14a and 14b. An SiO₂ film is buried in each of the trench grooves. The groove width of the trench groove 13 is formed to be smaller than the total value of the widths tₛₐ, tₛₐ of the trench grooves 14a, 14b, and similarly to the first embodiment of the trench groove 13, the amount of heat dissipation per unit length from the trench groove 14 can be suppressed as compared with the trench groove 13. As a result, the temperature Tₛₐᵥₑ of the sense MOSFET 2 at the time of current driving can be made to approach the temperature Tₘₐᵥₑ of the main MOSFET 1.

The number of trench grooves is not limited to this, the above object can be satisfied if the total value of the widths of all the trench grooves constituting the trench groove 13 is smaller than the total value of the widths of all the trench grooves constituting the trench groove 14.

As described in the first and second embodiments, it is not necessary to fill the trench groove 13 and the trench grooves 14a, 14b with the same insulating film, and the insulating film may be made of a different material so that the thermal conduction coefficient of the trench groove 13 is larger than the thermal conduction coefficient of the trench grooves 14a and 14b.

An example not forming part of the claimed invention will be described with reference to FIG. 5. FIG. 5 shows a plan view of a semiconductor device. A main MOSFET 1 is surrounded by a trench groove 13 and a sense MOSFET 2 is surrounded by a trench groove 14. The main MOSFET 1 and the sense MOSFET 2 are in contact with each other via the trench groove 14. By sharing part of the trench groove, the layout area can be reduced, and the temperature Tₛₐᵥₑ of the sense MOSFET can be raised relatively by heat radiation from the main MOSFET. As a result, the temperature Tₛₐᵥₑ of the sense MOSFET 2 at the time of current driving can be brought close to the temperature Tₘₐᵥₑ of the main MOSFET 1, and the change of the sense ratio with respect to the change of the driving current of the main MOSFET can be suppressed.

An application of the present invention will be described with reference to FIG. 6. FIG. 6 shows a circuit structure of a current control device having a microcontroller that controls a semiconductor element according to the present invention. This circuit is used for a linear solenoid driver when, for example, a linear solenoid is used as an electromagnetic load 36. A main NMOSFET 31 on a high side, a current detection circuit 29 on a high side, a main NMOSFET 33 on a low side, a current detection circuit 30 on a low side, a resistance element 35, a pre-driver 39 on a high side, and a pre-driver 40 on a low side are provided.

The current detection circuit 29 on the high side includes a sense NMOSFET 32 having a gate electrically connected to a gate of the main MOSFET 31 and a source electrically connected to the source of the main MOSFET 31. On the other hand, the drain of the sense NMOSFET 32 and the drain of the main MOSFET 31 are in a virtual short-circuit state by the operational amplifier. Therefore, the current I_{sH} flowing through the sense NMOSFET 32 is a value obtained by multiplying the current I_{mH} flowing through the main NMOSFET 31 by the sense ratio. The temperature Tₘₐᵥₑ of the main NMOSFET 31 increases in proportion to the current amount I_{sH}. However, according to the configuration of the present invention, by suppressing the heat dissipation from the trench groove of the sense NMOSFET 32 and reducing the temperature difference between the main NMOSFET 31 and the sense NMOSFET 32, it is possible to suppress the change in the sense ratio with respect to the change in the driving current of the main MOSFET 31.

Similarly, the current detection circuit 30 on the low side includes a sense NMOSFET 34 having a gate electrically connected to a gate of the main MOSFET 33 and a drain electrically connected a drain of the main MOSFET 33. On the other hand, the source of the sense NMOSFET 34 and the source of the main MOSFET 33 are in a virtual short-circuit state by the operational amplifier. Therefore, the current I_{sL} flowing through the sense NMOSFET 34 is a value obtained by multiplying the current I_{mL} flowing through the main NMOSFET 33 by the sense ratio. The temperature Tₘₐᵥₑ of the main NMOSFET 33 increases in proportion to the current amount I_{sL}. However, according to the configuration of the present embodiment, by suppressing the heat dissipation from the trench groove of the sense NMOSFET 34 and reducing the temperature difference between the main NMOSFET 33 and the sense NMOSFET 34, it is possible to suppress the change in the sense ratio with respect to the change in the driving current of the main MOSFET 33. As a result, the current control device can perform highly precise current control, and is suitable for an automatic transmission control unit (ATCU), an engine control unit (ECU), etc., that control the current of a solenoid.

### Reference Signs List

- 1: main MOSFET
- 2: sense MOSFET
- 3: first insulating film
- 4: second insulating film
- 5: main MOSFET source
- 6: main MOSFET gate
- 7: main MOSFET drain
- 8: source MOSFET source
- 9: source MOSFET gate
- 10: source MOSFET drain
- 11: SOI layer
- 12: semiconductor substrate
- 13: trench groove surrounding main MOSFET
- 14: trench groove surrounding sense MOSFET
- 15: STI trench
- 16: main MOSFET P-body layer
- 17: main MOSFET P-body connection P+layer
- 18: main MOSFET source N+layer
- 19: main MOSFET drain N+layer
- 20: sense MOSFET P-body layer
- 21: sense MOSFET P-body connection P+layer
- 22: sense MOSFET source N+layer
- 23: sense MOSFET drain N+layer
- 24: contact
- 25: wiring first layer
- 26: wiring connection layer
- 27: wiring second layer
- 28: gap
- 29: current detection circuit at high side
- 30: current detection circuit at low side
- 31: main NMOSFET at high side
- 32: sense NMOSFET at high side
- 33: main NMOSFET at low side
- 34: sense NMOSFET at low side
- 35: resistance element
- 36: electromagnetic load
- 37: boost circuit
- 38: power supply
- 39: pre-driver at high side
- 40: pre-driver at low side
- 41: main MOSFET
- 42: sense MOSFET
- 43: gate lead-out wiring first layer
- 44: sense MOSFET drain lead-out wiring second layer
- 45: main MOSFET drain lead-out wiring third layer
- 46: MOSFET common source lead-out wiring third layer

## Claims

1. A semiconductor element for current control comprising: on the same semiconductor substrate (12), a main MOSFET (1)configured to drive a current; and a sense MOSFET (2) that is connected in parallel to the main MOSFET and that is configured to perform current detection of the main MOSFET, wherein
the main MOSFET is surrounded by a first trench groove (13),
the sense MOSFET is surrounded by a second trench groove (14), wherein a thermal conductivity of the first trench groove surrounding the main MOSFET is larger than a thermal conductivity of the second trench groove surrounding the sense MOSFET,
**characterised in that:**
a thermal conduction coefficient (λₘ/tₘ) per unit length of the first trench groove surrounding the main MOSFET having the width tₘ and the thermal conductivity λₘ of material in the first trench is larger than a thermal conduction coefficient (λ_{s/}tₛ) per unit length of the second trench groove surrounding the sense MOSFET having a width tₛ and the thermal conductivity λₛ of material in the second trench, **in that**
a width of the second trench groove surrounding the sense MOSFET is larger than a width of the first trench groove surrounding the main MOSFET, and **in that**
a thermal resistance of the first trench groove surrounding the main MOSFET and a thermal resistance of the second trench groove surrounding the sense MOSFET are inversely proportional to the area of the element region surrounded by the first and second trench grooves , the thermal resistance of the first trench groove being determined by dividing the reciprocal of the thermal conduction coefficient of the first trench groove by the cross-sectional area around the main MOSFET of the first trench groove, and the thermal resistance of the second trench groove being determined by dividing the reciprocal of the thermal conduction coefficient of the second trench groove by the cross-sectional area around the sense MOSFET of the second trench groove.

2. The semiconductor element for current control according to claim 1, wherein
the main MOSFET has a structure in which a plurality of channels are arranged in a line at equal intervals,
the sense MOSFET has a structure in which a plurality of channels are arranged in a line at equal intervals, and
an interval between channels of the main MOSFET is equal to an interval between channels of the sense MOSFET.

3. The semiconductor element for current control according to claim 1, wherein
the semiconductor element for current control is suitable for detecting an output current of an application specific integrated circuit (ASIC) which is configured to output a driving current.

4. A current control device comprising:
a semiconductor element for current control according to claim 1; and
a microcontroller that is configured to control the semiconductor element for current control.

## Patentansprüche

1. Halbleiterelement zur Stromsteuerung, das Folgendes umfasst:
auf demselben Halbleitersubstrat (12) einen Haupt-MOSFET (1), der konfiguriert ist, einen Strom anzusteuern; und einen Erfassungs-MOSFET (2), der zu dem Haupt-MOSFET parallelgeschaltet ist und konfiguriert ist, eine Stromdetektion des Haupt-MOSFET auszuführen, wobei
der Haupt-MOSFET von einer ersten Grabenrille (13) umgeben ist,
der Erfassungs-MOSFET von einer zweiten Grabenrille (14) umgeben ist,
wobei die spezifische Wärmeleitfähigkeit der ersten Grabenrille, die den Haupt-MOSFET umgibt, größer ist als die spezifische Wärmeleitfähigkeit der zweiten Grabenrille, die den Erfassungs-MOSFET umgibt,
**dadurch gekennzeichnet, dass**:
ein Wärmeleitungskoeffizient (λ_{m/}tₘ) pro Einheitslänge der ersten Grabenrille, die den Haupt-MOSFET umgibt, wobei tₘ ihre Breite ist und λₘ die spezifische Wärmeleitfähigkeit des Materials in dem ersten Graben ist, größer ist als ein Wärmeleitungskoeffizient (λ_{s/}tₛ) pro Einheitslänge der zweiten Grabenrille, die den Erfassungs-MOSFET umgibt, wobei tₛ ihre Breite ist und λₛ die spezifische Wärmeleitfähigkeit des Materials in dem zweiten Graben ist,
dass eine Breite der zweiten Grabenrille, die den Erfassungs-MOSFET umgibt, größer ist als eine Breite der ersten Grabenrille, die den Haupt-MOSFET umgibt, und
dass ein Wärmewiderstand der ersten Grabenrille, die den Haupt-MOSFET umgibt, und ein Wärmewiderstand der zweiten Grabenrille, die den Erfassungs-MOSFET umgibt, umgekehrt proportional ist zu der Fläche des Elementbereichs, der von der ersten und der zweiten Grabenrille umgeben ist, wobei der Wärmewiderstand der ersten Grabenrille durch Dividieren des Kehrwerts des Wärmeleitungskoeffizienten des ersten Grabenrille durch die Querschnittsfläche um den Haupt-MOSFET der ersten Grabenrille bestimmt ist und der Wärmewiderstand der zweiten Grabenrille durch Dividieren des Kehrwerts des Wärmeleitungskoeffizienten der zweiten Grabenrille durch die Querschnittsfläche um den Erfassungs-MOSFET der zweiten Grabenrille bestimmt ist.

2. Halbleiterelement zur Stromsteuerung nach Anspruch 1, wobei
der Haupt-MOSFET eine Struktur besitzt, in der mehrere Kanäle in einer Linie in gleichen Intervallen angeordnet sind,
der Erfassungs-MOSFET eine Struktur besitzt, in der mehrere Kanäle in einer Linie in gleichen Intervallen angeordnet sind und
ein Intervall zwischen Kanälen des Haupt-MOSFET gleich einem Intervall zwischen Kanälen des Erfassungs-MOSFET ist.

3. Halbleiterelement zur Stromsteuerung nach Anspruch 1, wobei
das Halbleiterelement zur Stromsteuerung geeignet ist für die Detektion eines Ausgangsstroms einer anwendungsspezifischen integrierten Schaltung (ASIC), die konfiguriert ist, einen Ansteuerungsstrom auszugeben.

4. Stromsteuerungsvorrichtung, die Folgendes umfasst:
ein Halbleiterelement zur Stromsteuerung nach Anspruch 1; und
einen Mikrocontroller, der konfiguriert ist, das Halbleiterelement zur Stromsteuerung zu steuern.

## Revendications

1. Elément semi-conducteur de commande de courant, comprenant : sur le substrat du même semi-conducteur (12), un MOSFET principal (1) configuré pour piloter un courant ; et un MOSFET de détection (2) qui est connecté en parallèle au MOSFET principal et qui est configuré pour effectuer une détection de courant du MOSFET principal, dans lequel le MOSFET principal est entouré par une première rainure formant tranchée (13),
le MOSFET de détection est entouré par une seconde rainure formant tranchée (14),
dans lequel une conductivité thermique de la première rainure formant tranchée entourant le MOSFET principal est plus grande qu'une conductivité thermique de la seconde rainure formant tranchée entourant le MOSFET de détection,
**caractérisé en ce que** :
un coefficient de conductivité thermique (λₘ/tₘ) par longueur unitaire de la première rainure formant tranchée entourant le MOSFET principal ayant la largeur tₘ et la conductivité thermique λₘ d'un matériau dans la première tranchée est plus grande qu'un coefficient de conductivité thermique (λₛ/tₛ) par longueur unitaire de la seconde rainure formant tranchée entourant le MOSFET de détection ayant une largeur tₛ et la conductivité thermique λₛ d'un matériau dans la seconde tranchée,
**en ce que**
une largeur de la seconde rainure formant tranchée entourant le MOSFET de détection est plus grande qu'une largeur de la première rainure formant tranchée entourant le MOSFET principal, et
**en ce que**
une résistance thermique de la première rainure formant tranchée entourant le MOSFET principal et une résistance thermique de la seconde rainure formant tranchée entourant le MOSFET de détection sont inversement proportionnelles à la zone de la région d'élément entourée par la première et la seconde rainure formant tranchée, la résistance thermique de la première rainure formant tranchée étant déterminée en divisant la réciproque du coefficient de conductivité thermique de la première rainure formant tranchée par la zone de section transversale autour du MOSFET principal de la première rainure formant tranchée, et la résistance thermique de la seconde rainure formant tranchée étant déterminée en divisant la réciproque du coefficient de conductivité thermique de la seconde rainure formant tranchée par la zone de section transversale autour du MOSFET de détection de la seconde rainure formant tranchée.

2. Elément semi-conducteur de commande de courant selon la revendication 1, dans lequel
le MOSFET principal a une structure dans laquelle une pluralité de canaux sont agencés dans une ligne à intervalles égaux,
le MOSFET de détection a une structure dans laquelle une pluralité de canaux sont agencés dans une ligne à intervalles égaux, et
un intervalle entre des canaux du MOSFET principal est égal à un intervalle entre des canaux du MOSFET de détection.

3. Elément semi-conducteur de commande de courant selon la revendication 1, dans lequel
l'élément semi-conducteur de commande de courant est adapté pour détecter un courant de sortie d'un circuit intégré spécifique à l'application (application specific integrated circuit, ASIC) qui est configuré pour sortir un courant pilote.

4. Dispositif de commande de courant comprenant :
un élément semi-conducteur de commande de courant selon la revendication 1 ; et
un microcontrôleur qui est configuré pour commander l'élément semi-conducteur de commande de courant.
